Europäisches Patentamt

European Patent Office

Office européen des brevets

(19)

(11) Numéro de publication: **0 025 742**

**B1**

(12)

# FASCICULE DE BREVET EUROPEEN

(45) Date de publication du fascicule du brevet: **30.04.86**

(21) Numéro de dépôt: **80401251.6**

(22) Date de dépôt: **02.09.80**

(51) Int. Cl.⁴: **H 01 L 29/80**, H 01 L 29/10

(54) Transistor à effet de champ à fréquence de coupure élevée.

(30) Priorité: **10.09.79 FR 7922586**

(43) Date de publication de la demande:
**25.03.81 Bulletin 81/12**

(45) Mention de la délivrance du brevet:
**30.04.86 Bulletin 86/18**

(84) Etats contractants désignés:
**DE GB IT NL**

(56) Documents cités:
**EP-B-0 005 059**
**FR-A-2 096 602**
**GB-A-2 012 480**
**US-A-4 157 556**

**IEEE INTERNATIONAL SOLID STATE CIRCUITS CONFERENCE, vol. 18, no. 18, février 1975 New York US C. VERGNOLLE et al.: "An Adequate Structure for Power Microwave FETS", pages 66-67**

(73) Titulaire: **THOMSON-CSF**
**173, Boulevard Haussmann**
**F-75379 Paris Cedex 08 (FR)**

(72) Inventeur: **Delagebeaudeuf, Daniel**
**"THOMSON-CSF" SCPI 173, bld Haussmann**
**F-75360 Paris Cedex 08 (FR)**
Inventeur: **Nuyen, Trong Linh**
**"THOMSON-CSF" SCPI 173, bld Haussmann**
**F-75360 Paris Cedex 08 (FR)**

(74) Mandataire: **Taboureau, James et al**
**THOMSON-CSF SCPI 19, avenue de Messine**
**F-75008 Paris (FR)**

(56) Documents cités:
**JOURNAL OF THE ELECTROCHEMICAL SOCIETY, vol. 127, no. 8, août 1980 Princeton US P.K. VASLIDEV et al.: "High Resististy GaAs and GaA1As Buffer Layers for MESFET and IC Applications", pages 390C**

**Applied Phys. Letters 33 (1978.10.01), 7.p. 665-667**

Courier Press, Leamington Spa, England.

EP 0 025 742 B1

## Description

La présente invention concerne des perfectionnements aux dispositifs semiconducteurs de type MESFET et plus spécialement ceux dont la fréquence de coupure est élevée.

Parmi les transistors à effet de champ connus a été décrit un dispositif semiconducteur à effet de champ comportant, supportées par un substrat semi-isolant, d'une part les régions source et drain et d'autre part, une couche active en GaAs et une grille en $Al_xGa_{1-x}As$ formant avec la couche active une hétérojonction. Dans ce type de transistor, x est compris entre 0,1 et 0,8, et afin de simplifier le texte et les figures, on conviendra d'écrire simplement AlGaAs au lieu de $Al_xGa_{1-x}As$.

Ce dispositif a été réalisé sous plusieurs formes selon que la couche active est en:

—GaAs faiblement dopé de type N
—GaAs faiblement dopé de type P ou que la grille est en:
—AlGaAs recouverte ou non d'une couche d'oxyde.

L'ensemble de ces réalisations présente les caractéristiques communes suivantes:

—dans la zone d'interface de l'hétérojonction du côté GaAs, existe une couche d'électrons à grande mobilité,
—la concentration en électrons de cette couche est commandée par la polarisation de la grille en AlGaAs, recouverte ou non d'oxyde.

En ce qui concerne la qualité de l'interface, le couple $GaAs/Al_xGa_{1-x}As$ semble se comporter de façon quasi idéale. La présence d'éventuels pièges ou centres de recombinaison à l'interface n'a pu être révélée et la transition peut être très abrupte. De plus l'absence de charge négative d'interface autorise, dans les structures proposées, l'existence d'une couche d'accumulation électronique côté GaAs. L'hétéro-jonction satisfait alors au modèle proposé par Anderson dans un article intitulé "germanium arsenide heterojonctions" (IBM Journal, juillet 1960, pages 283—287). Cette propriété a été vérifiée par DINGLE et ses collaborateurs dans un article intitulé "Electron mobilities in modulation doped semiconductor heterojonction superlattice" [App. Phys. lett vol 33, n°7, p. 665—667 (1978)], sur une structure "superréseau" constituée par un empilement régulier de couches alternativement de GaAs non intentionnellement dopé et de $Al_xGa_{1-x}As$ dopé N. Il a mis en évidence, dans les puits de potentiel GaAs, une forte concentration électronique et mesuré une mobilité excellente proche de la mobilité du matériau GaAs non intentionnellement dopé. Il est très douteux qu'il s'agisse là d'un effet spécifique du super-réseau. Il s'agit plutôt d'une propriété des couches d'accumulation prédites par Anderson et localisées dans GaAs à chaque interface. La bonne mobilité observée résulterait alors du caractère de pureté du matériau GaAs les supportant. En résumé, dans les cas d'une hétérojonction isotype GaAs N (peu dopé)/$Al_xGa_{1-x}As$ (N):

—la transition peut être très abrupte;
—l'interface est quasi idéale; peu de pièges, de centres de recombinaison, de charge fixe;
—il existe une couche électronique d'accumulation dans le matériau GaAs;
—la mobilité dans la couche d'accumulation est proche de la mobilité en volume du matériau la supportant (GaAs) et donc n'est pas dégradée par la voisinage de l'interface.

C'est la grande mobilité des électrons dans la couche d'interface qui confère à ces dispositifs un avantage par rapport aux transistors à effet de champ connus: transistor à grille Schottky couramment dénommé MESFET, c'est-à-dire "Metal-Schottky-field effect transistor", en anglais, et transistor MOS (métal/oxyde/silicium) à déplétion mobilité d'électrons. Cependant, la commande de charge par la grille en AlGaAs présente des limitations.

En premier lieu, la charge commandée, c'est-à-dire le courant entre source et drain $I_{DS}$ varie comme la racine carrée de la tension appliquée sur grille $V_G$; autrement dit, les caractéristiques $I_{DS}/V_G$ ne sont pas linéaires. Ces caractéristiques non linéaires existent aussie dans les transistors MESFET ou MOSFET. Ce n'est pas un inconvénient majeur, mais il est plus commode pour l'utilisation de les rendre linéaires. C'est pourquoi, dans les transistors MESFET, la linéarisation est recherchée et quelquefois obtenue d'une manière relativement compliquée par la réalisation d'une couche active à profile de dopage variable.

En outre, la conception de la commande de charge par la grille en AlGaAs conduit à des structures particulières de transistor, qui différent de celles de transistors MESFET classiques surtout par la technologie des contacts de source, de drain et de grille. Leur fabrication nécessite donc une tecnnologie différente de celle des MESFET en GaAs, ce qui rend leur réalisation industrielle plus difficile.

Un transistor à effet de champ présentant une hétérostructure entre une couche de GaAs et une couche de AlGaAs, cell-ci étant située entre la couche de GaAs et le substrat, est en soi connu. Le document GB—A—2 012 480, par exemple, décrit un tel transistor dans lequel une couche de AlGaAs, interposée entre la couche active de GaAs et le substrat semi-isolant, crée une hétérojonction qui, par son effet de barrière, améliore le confinement des porteurs de charges et par conséquent améliore les performances du transistor. Mais la différence d'affinité électronique entre les deux couches est telle qu'en fonctionnement les porteurs de charges sont confinés dans la couche de GaAs, qui les génère elle-même, étant relativement dopée à $8.10^{16}$ e.cm$^{-3}$. Il n'y a pas création dans GaAs d'une couche d'accumulation d'électrons, fournis par

AlGaAs, dont le niveau de dopage n'est pas précisé. La transconductance de ce transistor est améliorée par le confinement par une barrière des porteurs de charge, mais par une augmentation de mobilité des électrons d'une couche d'accumulation.

La création d'une couche d'accumulation d'électrons très mobiles est décrite dans le brevet EP—B—0 005 059 qui prévoit de réaliser un MESFET qui possède une région de canal constituée par une succession de couches -c'est-à-dire au moins deux- de matériau à faible bande interdite, dopé à moins de $10^{14}$e.cm$^{-3}$ et de matériau à grande bande interdite, dopé à plus de $10^{16}$e.cm$^{-3}$. Le produit du taux de dopage par l'épaisseur de matériau à grande bande interdite est plus grand que le produit du taux de dopage par l'épaisseur du matériau à faible bande interdite: c'est l'une des conditions pour que le matériau à grande bande interdite et à faible affinité électronique perde des électrons au profit du matériau à faible bande interdiate et grande affinité électronique, ce qui crée une couche d'accumulation d'électrons très mobiles. Mais ce document, orienté sur les super-réseaux de couches d'épaisseur comprise entre 100 et 400 Å ne précise pas, dans le cas limite où il n'y a que deux couches, quelle est la couche qui est en contact avec le substrat et celle qui reçoit les métallisations de source, grille et drain du MESFET. Ce cas limite de deux couches seulement risque en outre de voir se développer un effet tunel, si les couches sont aussie fines que 100 Å.

Dans ce document il apparait que les contacts de source et de drain sont pris par l'intermediare de zones source et drain diffusés ou implantés à travers la sffucture multicouche jusqu'au substrat l'invention vise à réduire les résistances parasites d'accés de source et de drain ainsi que, selon un mode de réalisation avantageux, le conductance parallèle de sortie.

L'invention concerne un transistor à effet de champ à fréquence de coupure très élevée de type MESFET à haute mobilité électronique, comportant, supportées par un substrat semi-isolant, une première couche de n Ga$_{1-x}$Al$_x$As (0,1<×<0,8) et une deuxième couche de n$^-$GaAs formant une hétérojunction avec la première couche, des deux couches étant de dopage et d'épaisseurs tels qu'il se forme à leur interface une zone dite d'accumulation électronique, dans la couche de GaAs, ce transistor étant caractérisé en ce qu'une troisième couche de n GaAs, dopée à un niveau compris entre 1 et $5.10^{17}$ e.cm$^{-3}$ et d'épaisseur comprise entre 50 et 100 nm est déposée sur la deuxième couche de n$^-$GaAs, dont l'épaisseur (50—100 nm) est choisie pour être sensiblement égale à l'épaisseur de la zone d'accumulation d'électrons, pour le niveau de dopage (n<$10^{16}$e.cm$^{-3}$) de ladite deuxième couche de n$^-$GaAs. l'épaisseur de la troisième couche de n GaAs et son niveau de dopage étant choisis pour réduire les résistances parasites, de source R$_S$ et de drain R$_D$, et pour augmenter la transconductance, des électrodes de source, de grille et de drain étant déposées à la surface supérieure de cette de cette troisième couche.

L'invention sera mieux comprise grâce aux explications qui suivent, lesquelles s'appuient sur les figures qui représentent:

—figure 1: coupe·schématique d'un MESFET selon l'art connu,
—figure 2: coupe schématique d'un FET à hétéro-jonction et à grille Schottky,
—figure 3: schéma de bande d'une structure comportant une hétérojonction GaAs type N/AlGaAs de type N et une jonction Schottky,
—figure 4: coupe schématique d'une première réalisation de transistor FET à hétérojonction et à grille Schottky selon l'invention, permettant de réduire les résistances parasites de source R$_S$ et de drain R$_D$
—figure 5: coupe schématique d'une, structure permettant d'augmenter la résistance parallèle de sortie R$_B$ et de supprimer les capacités parasites.
—figure 6: coupe schématique d'une deuxième forme de réalisation de l'invention permettant une amélioration supplémentaire de celle-ci par augmentation de la résistance parallèle de sortie.

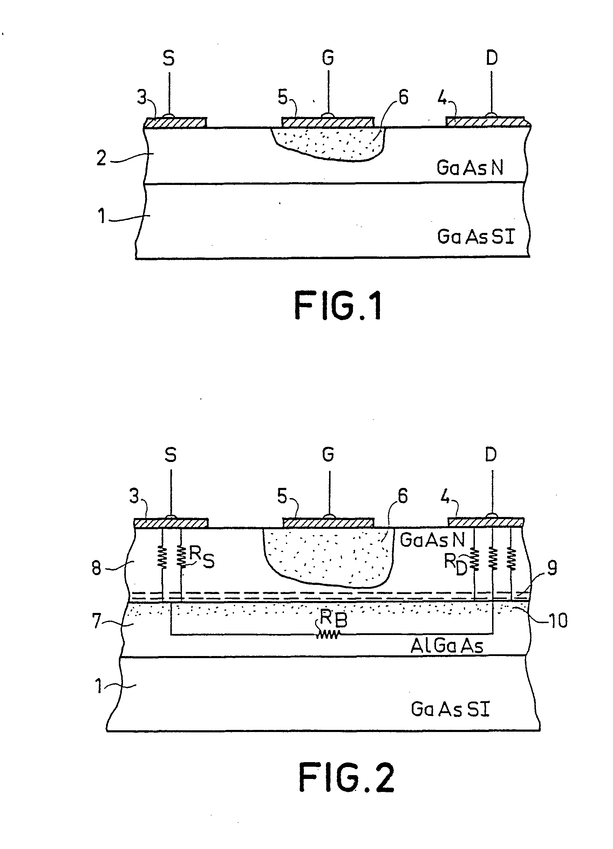

La figure 1 représente la coupe schématique d'un transistor MESFET selon l'art connu: sur un substrat 1 en GaAs semi-isolant est déposée une couche 2 en GaAs de type N et de dopage de l'ordre de $10^{17}$ cm$^{-3}$. Les électrodes 3 de source, 4 de drain et 5 de grille sont obtenues par métallisation. Sous l'action d'une tension négative de commande sur la grille 5, il se crée une zone 6 désertée d'électrons. Les électrons sont donc pincés dans un canal délimité par la zone désertée 6 et le substrat semi-isolant 1. En raison du dopage dans la couche 2 en GaAs, la mobilité, c'est-à-dire la vitesse de déplacement des électrons dans le canal est faible.

La figure 2 représente la couche schématique d'un transistor à hétérojonction et à grille Schottky que l'on peut appeler transistor MESFET à hétérojonction. Sur un substrat 7 en AlGaAs semi-isolant sont déposés successivement une couche 7 en AlGaAs dopé à un niveau supérieur à $10^{17}$ électrons/cm$^3$, et une couche 8 en GaAs de type N faiblement dopé au niveau de $10^{15}$ électrons/cm$^3$. Les électrodes 3 de source, 4 de drain et 5 de grille sont déposées et disposées comme dans un MESFET classique. La zone 9 d'accumulation d'électrons créée par l'hétéro-jonction GaAs/AlGaAs est située dans la couche 8 de GaAs, à proximité de la jonction. par action de polarisation de la grille Schottky 5, l'épaisseur de la zone désertée 6 peut être modulée, ainsi que la charge accumulée à l'interface, dans la zone 9. A cette zone 9 correspond une zone 10 de désertion d'électrons, située dans la couche 7 de AlGaAs, à proximité de l'hétérojonction. Cette figure met en évidence les resistances d'accès parasites R$_S$ et R$_D$ ainsi que la résistance de sortie R$_B$.

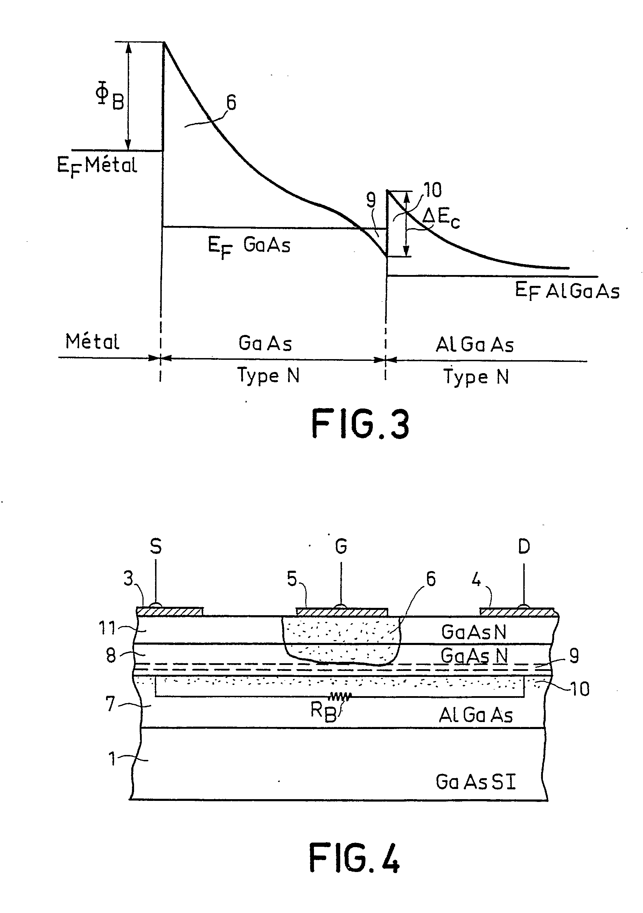

La figure 3 représente la schéma de bande de la structure: métal de grille Schottky/GaAs de type N faiblement dopé AlGaAs de type N, sous polarisation négative de la grille Schottky.

$E_F$ désigne le niveau de Fermi

$\varphi_B$ désigne la hauteur de la barrière de Schottky

$\Delta E_C$ désigne la discontinuité dans la bande de conduction à l'interface à l'hétérojonction ce qui représente la haute de barrière pour les électrons à l'interface de l'hétérojonction.

Les courbures de bande dans GaAs font apparaître la zone 6 de désertion d'électrons à l'interface avec la grille Schottky et la zone 9 d'accumulation d'électrons à l'interface avec GaAlAs. La courbure de bande dans GaAlAs fait apparaître la zone 10 de désertion d'électrons dans GaAlAs à proximité de l'interface avec GaAs. La polarisation négative de la grille Schottky fait étendre la zone désertée 6 et pour une valeur suffisamment élevée de cette tension, la zone désertée 6 s'étend jusqu'à l'interface avec GaAlAs. Cette tension est analogue à la tension de pincement dans un transistor MESFET classique. Elle dépend:

—du dopage de la couche 8 de GaAs
—de l'épaisseur de la couche 8 de GaAs
—du dopage de la couche 7 de GaAlAs
—de la concentration en aluminium dans AlGaAs.

En outre, la variation de la charge accumulée de la zone 9, sous l'action de la polarisation de la grille Schottky 5 qui module l'épaisseur de la zone dépeuplée 6, est une fonction linéaire de la tension de cette polarisation.

Une structure de transistor du type schématisé sur la figure 2, présente donc les propriétés recherchées, c'est-à-dire des caractéristiques $I_{DS}$—$V_G$ linéaires et une technologie des contacts source, drain et grille proche de celle des MESFET classiques. Cependant, elle présente encore des limitations:

1) l'épaisseur de la couche 8 en GaAs faiblement dopée de type n ($\sim 10^{15}$ électrons/cm$^3$), doit être de l'ordre d'un micron car à ce niveau de dopage l'épaisseur de la zone désertée 6 à polarisation nulle est de cet ordre de grandeur. Une telle épaisseur entraîne plusieurs conséquences:

—faible transconductance du dispositif, par rapport aux transistors MESFET classiques;
—résistances d'accès de source $R_S$ et de drain $R_D$ élevées.

2) La couche 7 en GaAlAs étant dopée à un niveau supérieur à $10^{17}$ électrons/cm$^3$, l'effet tunnel entre GaAs et GaAlAs, peut être important. De plus, étant dopée à $10^{17}$ électrons/cm$^3$, cette couche est faiblement résistive. En conséquence, il apparaît une faible résistance parallèle de sortie $R_B$, entre source et drain.

3) Du fait de l'existence d'une zone désertée 10 en électrons à l'interface de l'hétérojonction, du côté GaAlAs, il y apparaît des capacités parasites qui ont pour conséquence de limiter les performances du transistor.

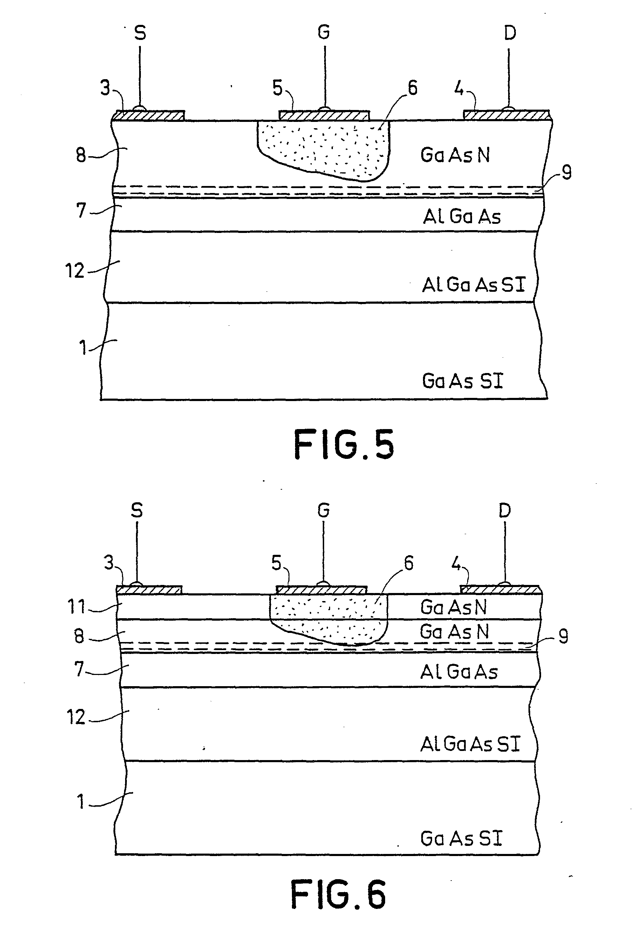

Ces trois limitations peuvent être évitées par la réalisation des structures décrites dans les figures 4 et 5.

La figure 4 représente une structure permettant à la fois d'augmenter la transconductance du dispositif et de réduire les résistances parasites $R_S$ et $R_D$; le transistor comporte comme celui de la figure 2 un substrat semi-isolant 1, une source 3, un drain 4, une grille 5 créant une zone désertée 6, une couche 7 en GaAlAs et une couche 8 en GaAs faiblement dopée de type n. Cependant, la couche 8 en GaAs est de faible épaisseur (500 à 1000 Å) et est associée à une couche 11 en GaAs de type n dopé au niveau de 1 à $5.10^{17}$ électrons/cm$^3$ environ, et d'épaisseur de 500 à 1000 Å environ. Les métallisations d'électrodes sont déposées sur cette couche 11. L'épaisseur de la zone 9 d'accumulation d'électrons étant d'environ 500 Å, on réduit par rapport à la structure proposée dans la figure 2, les résistances parasites $R_S$ et $R_D$ dans les proportions allant de $10^{-1}$ à $10^{-4}$. Compte tenu de l'épaisseur globale des deux couches superposées 8 et 11, la transconductance, toujours par rapport à la structure de la figure 2, s'améliore d'un facteur 6 à 10.

La figure 5 représente une structure permettant à la fois d'augmenter la résistance parallèle de sortie $R_B$ et de supprimer les capacités parasites. Le transistor comporte un substrat semi-isolant 1, une source 3, un drain 4, une grille 5, créant une zone désertée 6, une couche 7 en GaAlAs de type n dopé à un niveau supérieur à $10^{17}$ électrons/cm$^3$, et une couche 8 en GaAs faiblement dopé de type n. Cependant, le couche 7 en GaAlAs est de faible épaisseur 500 à 1000 Å environ, et une couche 12 en GaAlAs semi-isolant est intercalée entre le substrat 1 en GaAs semi-isolant et la couche 7 en GaAlAs dopé. L'épaisseur de la couche 7 en GaAlAs est choisie de faible épaisseur pour être sensiblement égale à l'épaisseur de zone désertée d'électrons 10 dans GaAlAs à l'interface de l'hétérojonction. Etant donc dépourvue d'électrons, cette zone 10 est de forte résistivité. Ainsi, entre le substrat semi-isolant 1 et la zone 9 d'accumulation, la structure est de forte résistivité ce qui a pour effet d'accroître la résistance parallèle de sortie $R_B$. Par absence de conduction dans la couche 7 GaAlAs, les capacités parasites sont, par rapport à une structure du type des figures 2 ou 4, diminuées d'un facteur supérieur à $10^3$.

La figure 6 représente la structure d'un transistor à effet de champ à hétérojonction, dans laquelle sont réunies les différentes structures partielles décrites à l'occasion des figures 2, 4 et 5. Ce transistor est donc constitué par l'ensemble des couches décrites depuis le substrat vers les électrodes:

— 1: substrat en GaAs semi-isolant,
—12: GaAlAs semi-isolant, à forte résistivité,
— 7: GaAlAs type n dopé à un niveau de l'ordre de $10^{17}$ électrons/cm$^3$,

— 8: GaAs type n dopé au niveau de $10^{15}$ électrons/cm³,

—11: GaAs type n dopé au niveau de $10^{17}$ électrons/cm³,

—3, 4, 5: les électrodes de source, drain et grille respectivement.

## Revendications

1. Transistor à effet de champ à fréquence de coupure très élevée de type MESFET à haute mobilité électronique comportant, supportées par un substrat semi-isolant (1), une première couche (7) de n $Ga_{1-x}Al_xAs$ (0,1<×<0,8) et une deuxième couche (8) de n⁻GaAs formant une hétérojonction avec la première couche (7), ces deux couches étant de dopage et d'épaisseurs tels qu'il se forme à leur interface une zone dite d'accumulation électronique, dans la couche de GaAs (8), ce transistor étant caractérisé en ce qu'une troisième couche (11) de n GaAs, dopée à un niveau compris entre 1 et $5.10^{17}$e.cm⁻³ et d'épaisseur comprise entre 50 et 100 nm est déposée sur la deuxième couche (8) de n⁻GaAs, dont l'épaisseur (50—100 nm) est choisie pour être sensiblement égale à l'épaisseur de la zone d'accumulation d'électrons (9), pour le niveau de dopage (n<$10^{16}$e.cm⁻³) de ladite deuxième couche (8) de n⁻GaAs, l'épaisseur de la troisième couche (11) de n GaAs et son niveau de dopage étant choisis pour réduire les résistances parasites, de source $R_S$ et de drain $R_D$, et pour augmenter la transconductance, des électrodes de source, de grille et de drain étant déposées à la surface supérieure de cette de cette troisième couche (11).

2. Transistor à effet de champ selon la revendication 1, caractérisé en ce que l'épaisseur de la couche (7) de $Ga_{1-x}Al_xAs$ est choisie pour être sensiblement égale à l'épaisseur de zone désertée d'électrons (10) à proximité de l'hétérojonction, pour le niveau de dopage ($5.10^{16}$ à $10^{18}$ électrons/cm³) de ladite couche (7) de $Ga_{1-x}Al_xAs$, les capacites parasites étant diminuées d'un facteur supérieure à $10^3$.

3. Transistor à effet de champ selon la revendication 2, caractérisé en ce que la première couche (7) de n $Ga_{1-x}Al_xAs$, située entre l'hétérojonction et le substrat (1), est d'épaisseur comprise entre 50 et 100 nm.

4. Transistor à effet de champ selon la revendication 1, caractérisé en ce qu'il comporte, en outre, une couche (12) en $Ga_{1-x}Al_xAs$ semi-isolant, intercalée entre le substrat (1) semi-isolant et la couche (7) de $Ga_{1-x}Al_xAs$ formant l'hétérojonction.

## Patentansprüche

1. Feldeffekttransistor mit sehr hoher Grenzfrequenz und vom MESFET-Typ mit hoher Elektronenbeweglichkeit, bei welchem ein halbisolierendes Substrat (1) eine erste Schicht (7) aus n $Ga_{1-x}Al_xAs$ (0,1<x<0,8) und eine zweite Schicht (8) aus n⁻GaAs trägt, welche einen Heteroübergang mit der ersten Schicht (7) bildet, wobei diese zwei Schichten derart dotiert und von solcher Dicke sind, daß an ihrer Grenzfläche eine sogenannte Elektronenansammlungszone in der GaAs-Schicht (8) gebildet ist, wobei dieser Transistor dadurch gekennzeichnet ist, daß eine dritte Schicht (11) aus n GaAs, die mit einem Niveau zwischen 1 und $5.10^{17}$e.cm⁻³ dotiert ist und eine Dicke zwischen 50 und 100 nm aufweist, auf der zweiten Schicht (8) aus n⁻GaAs aufgebracht ist, deren Dicke (50 bis 100 nm) derart gewählt ist, daß sie im wesentlichen gleich der Dicke der Elektronenansammlungszone (9) ist, für das Dotierungsniveau (n<$10^{16}$e.cm⁻³) der genannten zweiten Schicht (8) aus n⁻GaAs, wobei die Dicke der dritten Schicht (11) aus n GaAs und ihr Dotierungsniveau so gewählt sind, daß die parasitären Widerstände der Source-Elektrode $R_S$ und der Drain-Elektrode $R_D$ vermindert werden und die Transkonduktanz vergrößert wird, wobei Source- Gate- und Drain Elektroden an der Oberseite dieser dritten Schicht (11) aufgebraht sind.

2. Feldeffekttransistor nach Anspruch 1, dadurch gekennzeichnet, daß die Dicke der Schicht (7) aus $Ga_{1-x}Al_xAs$ so gewählt ist, daß sie im wesentlichen gleich der Dicke der von Elektronen verarmten Zone (10) in der Nähe des Heteroüberganges ist, wobei für das Dotierungsniveau ($5.10^{16}$ bis $10^{18}$ Elektronen/cm³) der genannten Schicht (7) aus $Ga_{1-x}Al_xAs$ die Störkapazitäten um einen Faktor von mehr als $10^3$ vermindert werden.

3. Feldeffekttransistor nach Anspruch 2, dadurch gekennzeichnet, daß die erste Schicht (7) aus n $Ga_{1-x}Al_xAs$, welche zwischen dem Heteroübergang und dem Substrat (1) liegt, eine Dicke zwischen 50 und 100 nm aufweist.

4. Feldeffekttransistor nach Anspruch 1, dadurch gekennzeichnet, daß er ferner eine Schicht (12) aus halbisolierendem $Ga_{1-x}Al_xAs$ umfaßt, welche zwischen das halbisolierende Substrat (1) und die Schicht (7) aus $Ga_{1-x}Al_xAs$ eingefügt ist, welche den Heteroübergang bilden.

## Claims

1. Field effect transistor having a very high cutoff frequency of the MESFET type and high electron mobility, comprising, carried by a semi-insulating substrate (1), a first layer (7) of n $Ga_{1-x}Al_xAs$ (0,1<×<0,8) and a second layer (8) of n⁻GaAs forming a heterojunction with the first layer (7), these two layers having dopings and thicknesses which are such that at the interface therebetween a so-called electron accumulation zone is formed in the layer (8) of GaAs, this transistor being characterized in that a third layer (11) of n GaAs doped at a level comprised between 1 and $5.10^{17}$e.cm⁻³ and of a thickness comprised between 50 and 100 nm is deposited on the second layer (8) of n⁻GaAs the thickness of which (50—100 nm) is selected to be substantially equal to the thickness of the electron accumulation zone (9), for the doping level (n<$10^{16}$e.cm⁻³) of said second layer (8) of n⁻GaAs, the thickness of the third layer (11) of n GaAs and its doping level being selected to reduce the parasitic resistances $R_S$ of the source and $R_D$ of the drain and to increase the transconductance, the source, gate and drain electrodes being deposited on the upper surface of this third layer (11).

2. Field effect transistor according to claim 1, characterized in that the thickness of the layer (7) of $Ga_{1-x}Al_xAs$ is selected to be substantially equal to the thickness of the electron depleted zone (10) in the neighborhood of the heterojunction, the parasitic capacities being reduced by a factor exceeding $10^3$, at the doping level ($5.10^{16}$ to $10^{18}$ electrones/$cm^3$ of said layer (7) of $Ga_{1-x}Al_xAs$.

3. Field effet transistor according to claim 2, characterized in that the first layer (7) of n $Ga_{1-x}Al_xAs$ located between the heterojunction and the substrate (1) has a thickness comprised between 50 and 100 nm.

4. Field effect transistor according to claim 1, characterized in that it further comprises a semi-insulating layer (12) of $Ga_{1-x}Al_xAs$ inserted between the semi-insulating substrate (1) and the layer (7) of $Ga_{1-x}As$ forming the heterojunction.

FIG.1

FIG.2

FIG.3

FIG.4

2

S        G        D

3      5      6      4

8      Ga As N

9

7      Al Ga As

12      Al Ga As SI

1      Ga As SI

# FIG.5

S        G        D

3      5      6      4

11      Ga As N

8      Ga As N

9

7      Al Ga As

12      Al Ga As SI

1      Ga As SI

# FIG.6